# EUROPEAN PATENT APPLICATION

(11) **EP 3 367 572 A1**
(43) Date of publication of application: **29.08.2018**
(21) Application number: 16856556.2
(22) Date of filing: 21.01.2016
(51) Int. Cl.: H03M 1/12, G06K 9/00

(54) **SIGNAL CONVERSION CIRCUIT AND FINGERPRINT RECOGNITION SYSTEM**

(30) Priority: 21.10.2015 CN 201510685724
(71) Applicant: Shenzhen Goodix Technology Co., Ltd., Futian Free Trade Zone Shenzhen, Guangdong 518000 (CN)
(72) Inventor: TAN, Bo, Shenzhen Guangdong 518000 (CN); ZHAN, Chang, Shenzhen Guangdong 518000 (CN)
(74) Representative: Valea AB
(86) International application number: PCT/CN2016/071680
(87) International publication number: WO 2017/067108

(57) **Abstract**

The present invention provides a signal conversion circuit and fingerprint identification system. The signal conversion circuit is configured to generate a first digital signal according to a first analog signal, and includes a comparator and counter. The comparator includes a first input terminal configured to receive the first analog signal, a second input terminal connected to a reference voltage generator and configured to receive a reference voltage, and an output terminal configured to output a second digital signal. The counter is connected to the output terminal, and is configured to generate a first digital signal. The signal conversion circuit according to the present invention has the advantages of simple circuit structure, small circuit area, low cost and low power consumption.

## Description

### TECHNICAL FIELD

The present invention relates to a signal conversion circuit and a fingerprint identification system, and in particular, relates to a signal conversion circuit and a fingerprint identification system having a simple circuit structure.

### BACKGROUND

With the development of science and technology, more and more portable electronic devices, such as mobile phones, digital cameras, tablet computers, laptop computers and the like, have become indispensable in people's life. Since the portable electronic devices are generally used by individuals and store some private data, the data stored in the electronic device, such as address books, pictures, personal information and the like, is privately owned. If an electronic device is lost, the data therein may be used by others, which may cause unnecessary losses. An electronic device may be prevented from being used by others by means of password protection. However, a password is easily leaked or cracked. Therefore, data security is low. In addition, users may use an electronic device only when inputting a correct password. If the password is forgotten, much inconvenience may be caused to the users. Therefore, a personal fingerprint identification system has been currently developed for identity authentication to improve data security.

Generally, a fingerprint identification system uses a pixel array circuit to receive a contact of a finger, and the pixel array circuit converts a capacitance formed between the pixel array circuit and the finger into a pixel output signal. Since the pixel output signal is an analog signal, the pixel output signal needs to be firstly converted into a digital signal, and then the digital signal is sent to a fingerprint judging module to determine whether the pixel array circuit corresponds to a finger ridge or a finger valley of the fingerprint. In the customary technologies, the pixel output signal is converted by an analog-to-digital converter (ADC) from an analog pixel output signal into a digital pixel output signal. However, the analog-to-digital converter has a complicated circuit structure, and thus need to occupy a large circuit area; furthermore, the production cost is increased and high power is consumed. Therefore, a conversion circuit with a simple circuit structure, a small circuit area, low cost and low power consumption is desired in the

### SUMMARY

Therefore, a main objective of the present invention is to provide a signal conversion circuit and a fingerprint identification system with simple circuit structure, small circuit area, low cost and low power consumption.

To solve the above technical problem, the present invention provides a signal conversion circuit. The signal conversion circuit is configured to generate a first digital signal according to a first analog signal, and includes a comparator and counter. The comparator includes a first input terminal configured to receive the first analog signal, a second input terminal connected to a reference voltage generator and configured to receive a reference voltage, and an output terminal, configured to output a second digital signal. The counter is connected to the output terminal, and is configured to generate a first digital signal.

Preferably, when the first analog signal is greater than the reference voltage, the second digital signal has a first potential, and when the first analog signal is less than the reference voltage, the second digital signal has a second potential.

Preferably, the signal conversion circuit is used in a fingerprint identification system. The fingerprint identification system includes a pixel array circuit, and the first input terminal is connected to the pixel array circuit.

Preferably, the pixel array circuit is configured to receive a contact of a finger, and convert a capacitance formed between the pixel array circuit and the finger into a pixel output signal. The pixel output signal is correlated to the first analog signal.

Preferably, the fingerprint identification system includes an amplifier, and the amplifier is connected between the pixel array circuit and the first input terminal, and configured to enhance a signal strength of the pixel output signal to form the first analog signal.

Preferably, a signal-to-noise ratio of the first analog signal is less than 3.

Preferably, the reference voltage generator includes a control circuit. The control circuit generates a definite voltage.

Preferably, the reference voltage generator further includes a digital-to-analog converter. The digital-to-analog converter is connected to the control circuit, and is configured to convert the definite voltage into the reference voltage.

To better solve the above technical problem, the present invention further provides a fingerprint identification system, the fingerprint identification system includes:
a pixel array circuit, configured to receive a contact of a finger, and convert a capacitance formed between the pixel array circuit and the finger into a pixel output signal;
a signal conversion circuit, connected to the pixel array circuit, and configured to generate a first digital signal according to a first analog signal, where the signal conversion circuit includes:
a comparator, including:
   a first input terminal, configured to receive the first analog signal;
   a second input terminal connected to a reference voltage generator, and configured to receive a reference voltage; and
   an output terminal, configured to output a second digital signal;
a counter connected to the output terminal, and configured to generate a first digital signal; and
a fingerprint judging module, connected to the signal conversion circuit, and configured to judge, according to the first digital signal, whether the pixel output signal corresponds to a finger ridge or a finger valley.

A signal conversion circuit according to the present invention retrieves a desired signal in a first analog signal and converts the desired signal into a first digital signal in the case of a low signal-to-noise ratio by using a comparator and a counter. The signal conversion circuit according to the present invention may replace a conventional ADC, and has the advantages of simple circuit structure, small circuit area, low cost and low power consumption.

### BRIEF DESCRIPTION OF THE DRAWINGS

FIG. 1 is a schematic diagram of a signal conversion circuit according to an embodiment of the present invention; and
FIG. 2 is a schematic diagram of a fingerprint identification system according to an embodiment of the present invention.

### DETAILED DESCRIPTION

In order to make the objectives, technical solutions, and advantages of the present invention clearer, the present invention is further described in detail below by reference to the embodiments and the accompanying drawings. It should be understood that the embodiments described here are only exemplary ones for illustrating the present invention, and are not intended to limit the present invention.

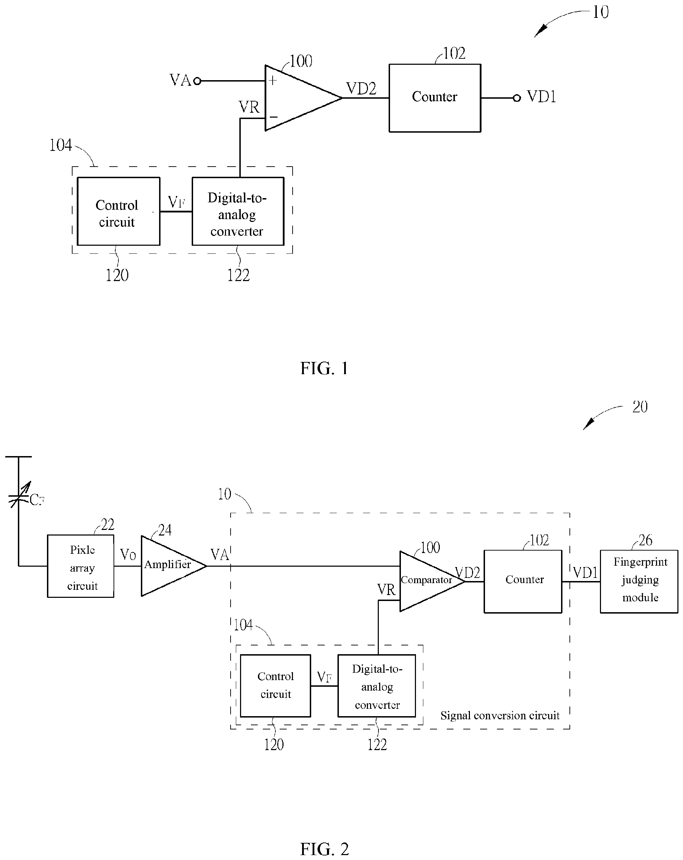

Referring to FIG. 1, FIG. 1 is a schematic diagram of a signal conversion circuit 10 according to an embodiment of the present invention. The signal conversion circuit 10 is configured to convert a first analog signal VA into a first digital signal VD1. The signal conversion circuit 10 includes a comparator 100, a counter 102 and a reference voltage generator 104. The comparator 100 includes a negative input terminal (marked by a sign "-"), a positive input terminal (marked by a sign "+") and an output terminal. The positive input terminal is configured to receive the first analog signal VA, and the negative input terminal is connected to the reference voltage generator 104 and configured to receive a reference voltage VR. The comparator 100 generates and outputs via the output terminal a second digital signal VD2 according to the first analog signal VA and the reference voltage VR; the second digital signal VD2 may be logic 0 or logic 1. In an embodiment, when the first analog signal VA is greater than the reference voltage VR, the second digital signal VD2 is logic 1 (corresponding to a first potential); and when the first analog signal VA is less than the reference voltage VR, the second digital signal VD2 is logic 0 (corresponding to a second potential). The counter 102 is connected to the output terminal of the comparator 100, and configured to accumulate the second digital signal VD2 to generate the first digital signal VD1. In other words, the first digital signal VD1 is an accumulated result of the second digital signal VD2. In addition, the reference voltage generator 104 may include a control circuit 120; the control circuit 120 is configured to generate a definite voltage V_{F}. When the definite voltage V_{F} is a digital voltage, the reference voltage generator 104 may further include a digital-to-analog converter 122; the digital-to-analog converter 122 is connected between the control circuit 120 and the negative input terminal, and the digital-to-analog converter 122 is configured to convert the definite voltage V_{F} of the digital voltage to an analog reference voltage VR.

The working principle of the signal conversion circuit 10 is described as follows. The first analog signal VA include a desired signal sig and noise noi; that is, the first analog signal VA is an accumulated result of the desired signal sig and noise noi, and the mathematical formula may be expressed as: VA=sig+noi, in which the noise noi complies with a probability distribution. It should be noted that the probability that the first analog signal VA is greater than the reference voltage VR (referred to as Pr(VA>VR)) and the desired signal sig have monotonicity, that is, the greater the desired signal sig, the greater the probability (Pr(VA>VR)) that the first analog signal VA is greater than the reference voltage VR; on the contrary, the smaller the desired signal sig, the smaller the probability (Pr(VA>VR)) that the first analog signal VA is greater than the reference voltage VR. In other words, the probability (Pr(VA>VR)) that the first analog signal VA is greater than the reference voltage VR reflects the strength of the desired signal sig. In the other respect, through sampling for N times (N is a positive integer), the first digital signal VD1 (which is the accumulated result of the second digital signal VD2) may reflect the probability (Pr(VA>VR)=VD1/N) that the first analog signal VA is greater than the reference voltage VR, that is, the first digital signal VD1 may reflect that the strength of the desired signal sig. Simply, the signal conversion circuit 10 may retrieve the strength of the desired signal sig in the first analog signal VA by using the comparator 100 and counter 102, and become the first digital signal VD1.

In the other aspect, the signal conversion circuit 10 is applicable to a system with a low signal-to-noise ratio (SNR), and particularly to the system with the SNR less than 3 (lower than 4.77 dB), for example, a fingerprint identification system. Referring to FIG. 2, FIG. 2 is a schematic diagram of a fingerprint identification system 20 according to an embodiment of the present invention. The signal conversion circuit 10 is applied in the fingerprint identification system 20, and includes a pixel array circuit 22, an amplifier 24, and a fingerprint judging module 26. The pixel array circuit 22 is configured to receive a contact of a finger, and convert a contact capacitance C_{F} formed between the pixel array circuit 22 and the finger into a pixel output signal Vo. The amplifier 24 is connected to the pixel array circuit 22, and is configured to enhance a signal strength of the pixel output signal Vo to form the first analog signal VA. The positive input terminal of the comparator 100 in the signal conversion circuit 10 is connected to the amplifier 24. The signal conversion circuit 10 is configured to retrieve a strength of a desired signal sig in the first analog signal VA to form the first digital signal VD1; the strength of the desired signal sig reflects a strength of the contact capacitance C_{F}. The signal conversion circuit 10 outputs the first digital signal VD1 to the fingerprint judging module 26, and the fingerprint judging module 26 judges, according to the first digital signal VD1, whether the pixel output signal Vo corresponds a finger ridge or a finger valley.

As seen from the above embodiment, a signal conversion circuit according to the present invention retrieves a desired signal in a first analog signal and converts the desired signal into a first digital signal in the case of a low signal-to-noise ratio by using a comparator and counter. The signal conversion circuit according to the present invention may replace a conventional ADC, and has the advantages of simple circuit structure, small circuit area, low cost and low power consumption.

It should be noted that the preceding embodiments are used to describe the concepts of the present invention. A person skilled in the art may make different modifications to the present invention without any limitation to the above given embodiments. For example, the amplifier is only used to enhance the signal strength of the pixel output signal Vo, which is not limited thereto. In case that the signal strength of the pixel output signal is sufficient, the fingerprint identification system may directly connect the positive input terminal of the comparator to the pixel array circuit, which also pertains to the scope of the present invention. In addition, the reference voltage generator may directly generate an analog reference voltage, without the need of using a digital-to-analog converter to convert the analog reference voltage.

To sum up, in the present invention, a desired signal in a first analog signal is retrieved and the desired signal is converted into a first digital signal in the case of a low signal-to-noise ratio only by using a comparator and counter. The signal conversion circuit of the present invention may replace an ADC applicable to a fingerprint identification system, such that the fingerprint identification system has the advantages of simple circuit structure, small circuit area, low cost and low power consumption.

The above descriptions are merely preferred embodiments of the present invention, but not intended to limit the present invention. Any modification, equivalent replacement, and improvement made without departing from the spirit and principle of the present invention shall fall within the protection scope of the present invention.

## Claims

1. A signal conversion circuit, comprising:
a comparator, comprising:
a first input terminal, configured to receive a first analog signal;
a second input terminal connected to a reference voltage generator, and configured to receive a reference voltage; and
an output terminal, configured to output a second digital signal; and
a counter connected to the output terminal, and configured to generate a first digital signal.

2. The signal conversion circuit according to claim 1, wherein when the first analog signal is greater than the reference voltage, the second digital signal has a first potential, and when the first analog signal is less than the reference voltage, the second digital signal has a second potential.

3. The signal conversion circuit according to claim 1, wherein the signal conversion circuit is used in a fingerprint identification system, wherein the fingerprint identification system comprises a pixel array circuit, and the first input terminal is connected to the pixel array circuit.

4. The signal conversion circuit according to claim 3, wherein the pixel array circuit is configured to receive a contact of a finger, and convert a capacitance formed between the pixel array circuit and the finger into a pixel output signal, wherein the pixel output signal is correlated to the first analog signal.

5. The signal conversion circuit according to claim 4, wherein the fingerprint identification system further comprises an amplifier, wherein the amplifier is connected between the pixel array circuit and the first input terminal, and configured to enhance a signal strength of the pixel output signal to form the first analog signal.

6. The signal conversion circuit according to claim 1, wherein a signal-to-noise ratio of the first analog signal is less than 3.

7. The signal conversion circuit according to claim 1, wherein the reference voltage generator comprises a control circuit, wherein the control circuit generates a definite voltage.

8. The signal conversion circuit according to claim 7, wherein the reference voltage generator further comprises a digital-to-analog converter, wherein the digital-to-analog converter is connected to the control circuit, and is configured to convert the definite voltage into the reference voltage.

9. A fingerprint identification system, comprising:
a pixel array circuit, configured to receive a contact of a finger, and convert a capacitance formed between the pixel array circuit and the finger into a pixel output signal;
a signal conversion circuit, connected to the pixel array circuit, and configured to generate a first digital signal according to a first analog signal, wherein the signal conversion circuit comprises:
a comparator, comprising:
a first input terminal, configured to receive the first analog signal;
a second input terminal connected to a reference voltage generator, and configured to receive a reference voltage;
an output terminal, configured to output a second digital signal;
a counter connected to the output terminal, and configured to generate a first digital signal; and
a fingerprint judging module, connected to the signal conversion circuit, and configured to judge, according to the first digital signal, whether the pixel output signal corresponds to a finger ridge or a finger valley.

10. The fingerprint identification system according to claim 9, wherein when the first analog signal is greater than the reference voltage, the second digital signal has a first potential, and when the first analog signal is less than the reference voltage, the second digital signal has a second potential.

11. The fingerprint identification system according to claim 9, further comprising:
an amplifier, connected between the pixel array circuit and the first input terminal, and configured to enhance a signal strength of the pixel output signal to form the first analog signal.

12. The fingerprint identification system according to claim 9, wherein a signal-to-noise ratio of the first analog signal is less than 3.

13. The fingerprint identification system according to claim 9, wherein the reference voltage generator comprises a control circuit, wherein the control circuit generates a definite voltage.

14. The fingerprint identification system according to claim 13, wherein the reference voltage generator further comprises a digital-to-analog converter, wherein the digital-to-analog converter is connected to the control circuit, and is configured to convert the definite voltage into the reference voltage.
